# FASCICULE DE BREVET EUROPEEN

(11) **EP 0 648 017 B1**
(45) Date de publication et mention de la délivrance du brevet: **29.12.1997**
(21) Numéro de dépôt: 94410084.1
(22) Date de dépôt: 10.10.1994
(51) Int. Cl.: H03K 5/26, G06F 1/04

(54) **Dispositif de surveillance du déphasage entre deux signaux d'horloge**
Vorrichtung zur Überwachung der Phasenverschiebung zwischen zwei Taktsignalen
Device for monitoring phase skew between two clock signals

(30) Priorité: 11.10.1993 FR 9312451
(43) Date de publication de la demande: 12.04.1995
(73) Titulaire: SGS-THOMSON MICROELECTRONICS S.A., 94250 Gentilly (FR)
(72) Inventeur: Schoellkopf, Jean-Pierre, F-38000 Grenoble (FR)
(74) Mandataire: de Beaumont, Michel

(56) Documents cités:
- US-A- 5 095 454
- US-A- 5 159 279
- WESCON CONFERENCE RECORD, vol.36, Novembre 1992, NORTH HOLLYWOOD, CA, US pages 15 - 20, XP000350068 FLUKER ET AL. 'High Resolution Skew Measurement'

## Description

La présente invention concerne les circuits électroniques dont divers éléments nécessitent l'utilisation d'une horloge distribuée sous la forme de plusieurs signaux d'horloge de même fréquenoe et normalement de même phase, et concerne plus particulièrement un circuit permettant de vérifier si le déphasage (skew) entre deux des signaux d'horloge est inférieur à une limite maximale tolérable.

Un grand nombre de circuits comprennent des éléments, tels que des bascules, des compteurs etc. qui doivent être synchronisés sur un signal d'horloge commun. Sur une puce de circuit intégré, divers éléments à synchroniser sont éparpillés, de manière que le signal d'horloge est amené à ces éléments par des liaisons de longueurs distinctes dont certaines sont relativement longues par rapport à d'autres. Sur une puce de circuit intégré, la capacité d'une liaison croit avec sa longueur. Une liaison d'horloge est en général commandée par un amplificateur délivrant un courant maximal déterminé par la taille de ses transistors. Ainsi, la pente des fronts d'un signal d'horloge délivré sur une ligne croit avec le courant maximal de l'amplificateur et diminue avec la longueur de la ligne (la capacité de la ligne). Un signal d'horloge est supposé présenter des fronts raides. Par conséquent, si la longueur des lignes d'horloge est importante, il faut accroitre le courant de sortie des amplificateurs. Toutefois, si l'on accroît le courant dans une ligne au-delà d'une certaine limite, il faut également accroître la section de la ligne, car elle risquerait sinon de se détériorer à long terme. L'accroissement de section d'une ligne ne peut, en général, être obtenu qu'en augmentant la largeur des conducteurs sur la puce. Cette augmentation de largeur est limitée et souvent incompatible avec un grand nombre de systèmes de conception de circuits intégrés car elle entraîne, outre une augmentation de surfaoe de la puce, des problèmes de placement et de routage des éléments de la puce.

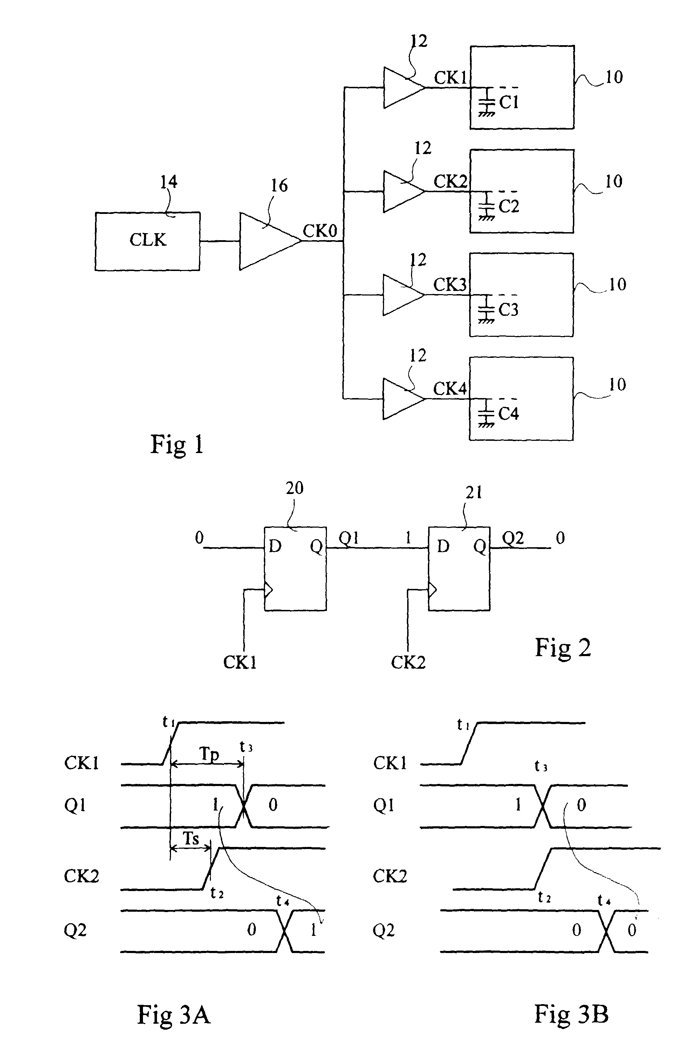

La figure 1 représente une solution couramment adoptée pour distribuer une horloge sur une puce de circuit intégré. Les éléments du circuit intégré sont regroupés en plusieurs zones 10 de forme ramassée (rectangulaire proche du carré), de manière que les liaisons à l'intérieur de ces zones présentent une longueur maximale réduite. A chaque zone 10 est fourni un signal d'horloge distinct CK1, CK2... par l'intermédiaire d'un amplificateur de courant 12 respectif. Les amplificateurs 12 reçoivent tous un signal d'horloge global CK0 fourni par un générateur d'horloge 14 par l'intermédiaire d'un amplificateur 16.

Avec cette configuration, chaque signal d'horloge CK1, CK2... est fourni à une ligne de longueur réduite. Par conséquent, pour obtenir des fronts de raideur acceptable des signaux d'horloge, il n'est pas nécessaire d'alimenter ces lignes d'horloge avec un courant trop important nécessitant l'augmentation de leur largeur.

Toutefois, les lignes CK1, CK2 etc. sont généralement de longueurs différentes, et présentent ainsi des capacités différentes. Les amplificateurs 12 étant sensiblement de mêmes caractéristiques, on obtient des fronts de pentes différentes sur les lignes d'horloge. Ces différentes pentes entraînent des déphasages (skew) entre les signaux d'horloge. Comme on le verra ci-après, un déphasage trop important entre deux signaux d'horloge peut s'avérer néfaste.

Pour réduire les déphasages, il est possible de rallonger les lignes d'horloge les plus courtes. Toutefois, cette méthode, outre le fait qu'elle rend plus difficile la conception des circuits intégrés et qu'elle augmente la surface, fournit des résultats aléatoires qui dépendent de la technologie utilisée pour fabriquer le circuit intégré.

En conséquence, même si l'on prend certaines précautions, il subsistera toujours des déphasages entre les différents signaux d'horloge.

Des circuits particulièrement sensibles aux déphasages entre les signaux d'horloge sont les registres à décalage, dans le cas où des bascules de ces registres à décalage se trouvent dans des zones 10 différentes, c'est-à-dire qu'elles sont validées par des signaux d'horloge différents.

La figure 2 représente deux bascules 20 et 21 de type D connectées selon une configuration de registre à décalage. La bascule 20 est validée, par exemple, par le signal d'horloge CK1 et reçoit un signal à décaler, provenant par exemple d'une bascule précédente, sur une entrée D. La bascule 21 est validée par le signal d'horloge CK2, par exemple, et reçoit sur son entrée D la sortie Q1 de la bascule 20. On considère ci-après l'exemple où l'entrée D de la bascule 20 est à 0 et les sorties Q1 et Q2 respectivement à 1 et à 0.

En fonctionnement normal, le 0 à l'entrée de la bascule 20 est transmis sur la sortie Q1 et le 1 de la sortie Q1 est transmis sur la sortie Q2 dès la survenue pratiquement simultanée de deux fronts montants des signaux CK1 et CK2.

La figure 3A représente un chronogramme illustrant un fonctionnement normal du registre à décalage de la figure 2, dans le pire cas où le signal d'horloge CK1 est en avance de phase par rapport au signal d'horloge CK2, d'une durée Ts.

A un instant t₁, survient un front montant du signal d'horloge CK1. L'entrée D de la bascule 20 est à 0, la sortie Q1 de cette bascule est à 1 et la sortie Q2 de la bascule 21 est à 0. La bascule 20 répond à ce front avec un certain retard Tp appelé temps de propagation de la bascule. Ainsi, à un instant t₃=t₁+Tp, la sortie Q1 bascule à 0, l'état présent à l'entrée D de la bascule 20 à l'instant t₁.

Entre temps, à un instant t₂=t₁+Ts, survient un front montant du signal d'horloge CK2. Comme pour la bascule 20, la sortie Q2 de la bascule 21 change en retard à un instant t₄=t₂+Tp. La sortie Q2 de la bascule 21 passe à 1, l'état présent à l'entrée de la bascule 21 à l'instant t₂.

Une bascule présente ce que l'on appelle un temps de maintien Th qui correspond au temps minimal pendant lequel un état doit être maintenu à l'entrée de la bascule après son instant de validation pour que cette valeur soit effectivement prise en compte (transférée à la sortie de la bascule). Si ce temps de maintien Th n'est pas respecté, la bascule fonctionne de manière erronée. Dans l'exemple de la figure 3A, le temps de maintien Th de la bascule 21 est supposé respecté, c'est-à-dire que l'on a Ts < Tp-Th.

La figure 3B représente un cas de fonctionnement erroné. Par rapport au cas de la figure 3A, le déphasage Ts entre les signaux CK1 et CK2 est augmenté, de manière que l'on a Ts > Tp-Th. A l'instant t₄, la sortie Q2 bascule à l'état que prend la sortie Q1 après l'instant t₃, c'est-à-dire reste à 0 au lieu de basculer à 1 ; l'état 1 est perdu.

Dans une phase de test de circuit intégré après fabrication, lorsqu'un défaut de fonctionnement est détecté, il est généralement difficile de déterminer l'origine du défaut. Le défaut pourrait très bien être dû à un déphasage trop important entre les différents signaux d'horloge, mais ceci est difficile à vérifier de manière fiable car le temps de maintien Th des bascules varie d'une puce à l'autre et dépend de la technologie utilisée.

Un objet de la présente invention est de prévoir un dispositif de surveillance du déphasage entre les divers signaux d'horloge pour, lors d'une phase de test du circuit intégré, générer un signal d'alarme lorsque le déphasage entre deux signaux d'horloge quelconques est trop important.

Cet objet est atteint grâce à un dispositif de surveillance du déphasage entre deux signaux d'horloge quelconques parmi plusieurs signaux d'horloge de même fréquence. Les deux signaux d'horloge de chaque couple possible de signaux d'horloge valident respectivement deux bascules successives initialement à des états distincts, l'ensemble des bascules étant connecté dans une configuration de registre à décalage rebouclé. Un signal d'alarme est fourni par une porte OU Exclusif recevant les sorties de deux bascules successives du registre à décalage.

Selon un mode de réalisation de la présente invention, l'état du signal d'alarme est stocké dans une bascule validée par l'inverse de l'un des signaux d'horloge.

Ces objets, caractéristiques et avantages ainsi que d'autres de la présente invention seront exposés en détail dans la description suivante de modes de réalisation particuliers faite à titre non limitatif à l'aide des figures jointes parmi lesquelles :
la figure 1, précédemment décrite, représente un réseau classique de distribution d'une horloge dans un circuit électronique ;
la figure 2 représente un registre à décalage classique ;
les figures 3A et 3B représentent des chronogrammes illustrant un bon et un mauvais fonctionnement du registre à décalage de la figure 2 ;
la figure 4 représente un mode de réalisation de circuit de vérification selon l'invention du déphasage entre deux signaux d'horloge ; et
la figure 5 représente un mode de réalisation de circuit de vérification selon l'invention du déphasage entre deux signaux d'horloge quelconques parmi plusieurs signaux d'horloge.

La présente invention propose, pour détecter que le déphasage entre deux signaux d'horloge est trop important, d'utiliser un registre à décalage témoin dont on détecte le fonctionnement défectueux pour activer un signal d'alarme.

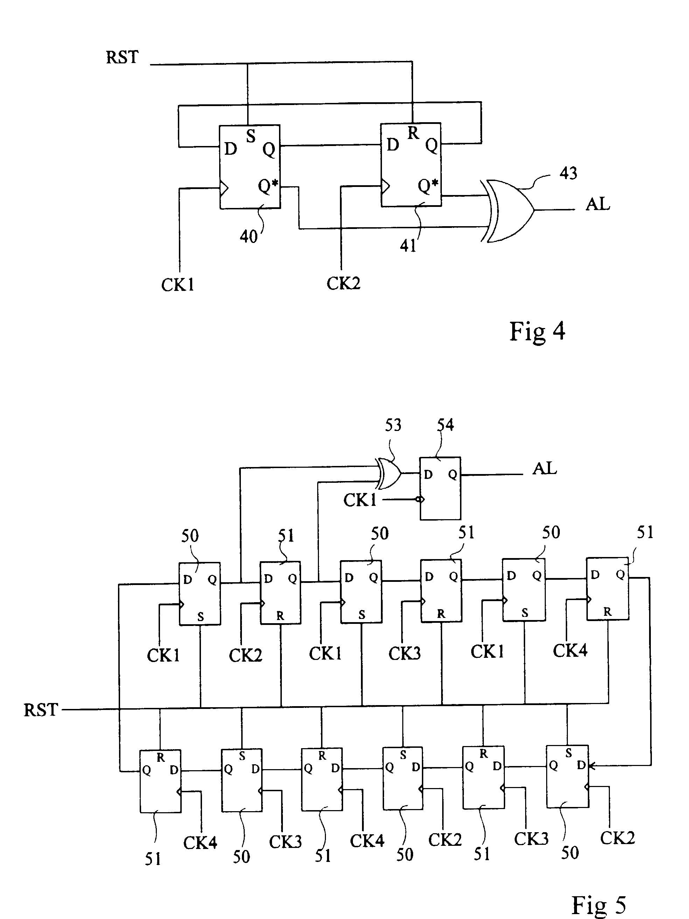

La figure 4 représente un tel registre à décalage témoin permettant, selon l'invention, de détecter un déphasage trop important entre deux signaux d'horloge CK1 et CK2. Deux bascules 40 et 41 sont connectées selon une configuration de registre à décalage rebouclé, c'est-à-dire que la sortie Q de la bascule 40 est reliée à l'entrée D de la bascule 41 et que la sortie de la bascule 41 est fournie à l'entrée D de la bascule 40. La bascule 40 est validée par le signal d'horloge CK1 et la bascule 41 est validée par le signal d'horloge CK2. En outre, un signal d'initialisation RST est fourni à une entrée de "mise à 1" S de la bascule 40 et à une entrée de "mise à 0" R de la bascule 41. Le signal RST est par exemple un signal qui est activé à la mise sous tension du circuit. Une porte OU Exclusif 43 reçoit les sorties inversées Q* des bascules 40 et 41. Cette porte 43 pourrait également recevoir les sorties non inversées Q de ces bascules. La sortie de la porte 43 fournit un signal d'alarme AL.

A la mise sous tension du circuit, la bascule 40 est à 1 et la bascule 41 à 0. En fonctionnement normal, lorsque le déphasage entre les signaux d'horloge CK1 et CK2 est acceptable, le 1 initialement dans la bascule 40 est transféré d'une bascule à l'autre à chaque front montant des signaux d'horloge CK1 et CK2. Les entrées de la porte 43 sont en permanence à des états différents ; en conséquence le signal AL est à 1.

Si le déphasage entre les signaux d'horloge CK1 et CK2 est trop important, le 1 ou le 0 à la sortie Q d'une première des bascules change d'état trop tôt pour que l'autre bascule puisse en tenir compte. En conséquence, les deux bascules sont au même état 0 ou 1. La sortie de la porte 43 passe alors à 0 et indique une défaillance.

Si l'on a n signaux d'horloge CK1 à CKn à vérifier, on peut utiliser le circuit de la figure 4 pour chaque couple de signaux CKi, CKj où i, j = 1, 2, 3... n et i<j, ce qui nécessite n(n-1)/2 circuits du type de la figure 4. Toutes les sorties des portes 43 sont combinées alors dans une porte OU pour former le signal d'alarme AL.

La figure 5 représente un mode de réalisation plus avantageux, dans l'exemple où n=4, pour réaliser un tel circuit. Dans le cas général, n(n-1) bascules sont connectées selon une configuration de registre à décalage rebouclé (le nombre n(n-1) correspond au nombre total de couples possibles de signaux d'horloge). Une bascule, désignée par 50, sur chaque deux bascules successives du registre à décalage est mise à 1 par un signal d'initialisation RST et les autres bascules, désignées par 51, sont mises à 0 par le signal RST. Deux bascules successives sont validées par deux signaux d'horloge respectifs de manière que les deux signaux d'horloge de chaque couple possible valident deux bascules successives du registre à décalage. Dans l'exemple de la figure 5, les bascules successives 50, 51 sont validées selon cette règle, respectivement par les signaux CK1, CK2, CK1, CK3, CK1, CK4, CK2, CK3, CK2, CK4, CK3, CK4. Bien entendu, de nombreuses autres combinaisons sont possibles pour obtenir le résultat attendu.

Une porte OU Exclusif 53 reçoit les sorties Q de deux bascules successives. La sortie de la porte 53 est fournie à l'entrée D d'une bascule 54 validée par l'inverse de l'un des signaux d'horloge, par exemple CK1. La sortie Q de la bascule 54 fournit de manière stable le signal d'alarme AL.

En fonctionnement normal, deux bascules successives sont toujours à des états différents. Ainsi, les deux entrées de la porte 53 sont à des états différents ; le signal d'alarme AL est à 0.

Lorsque deux signaux d'horloge sont trop déphasés l'un par rapport à l'autre, deux bascules successives correspondantes seront mises à un état identique. Ces deux états identiques sont décalés à chaque cycle d'horloge jusqu'à ce qu'ils atteignent les deux entrées de la porte 53. Alors, la sortie de la porte 53 passe à 1, ce 1 étant mémorisé dans la bascule 54 au front descendant suivant du signal CK1. Ces deux états identiques continuent à être décalés et la sortie de la porte 53 repasse à 0 mais le signal d'alarme reste mémorisé dans la bascule 54.

La solution de la figure 5 permet d'utiliser une seule porte OU Exclusif pour n signaux d'horloge alors que la solution proposée en relation avec la figure 4 nécessitait n(n-1)/2 portes OU Exclusif.

Un dispositif de surveillance selon l'invention occupe une faible surface sur une puce de circuit intégré. La ligne fournissant le signal d'alarme AL correspondra à un plot de la puce ou bien à une métallisation agrandie de manière que l'on puisse relever l'état de cette ligne lors d'une phase de test, à l'aide d'une pointe.

## Revendications

1. Dispositif de surveillance du déphasage entre deux signaux d'horloge quelconques parmi plusieurs signaux d'horloge (CK1-CKn) de même fréquence, caractérisé en ce que les deux signaux d'horloge de chaque couple possible de signaux d'horloge valident respectivement deux bascules sucoessives (40, 41; 50, 51) initialement à des états distincts dans un ensemble de bascules connectées dans une configuration de registre à décalage rebouclé, et en ce que un signal d'alarme (AL) est fourni par une porte OU Exclusif (43, 53) recevant les sorties de deux bascules successives du registre à décalage.

2. Dispositif de surveillance selon la revendication 1, caractérisé en ce que l'état du signal d'alarme est stocké dans une bascule (54) validée par l'inverse de l'un des signaux d'horloge (CK1).

## Patentansprüche

1. Vorrichtung zur Überwachung der Phasenverschiebung bzw. -versetzung zwischen zwei beliebigen unter mehreren Taktsignalen (CK1-CKn) gleicher Frequenz,
dadurch gekennzeichnet, daß die beiden Taktsignale jedes möglichen Paars von Taktsignalen zwei anfänglich in bestimmten Zuständen befindliche aufeinanderfolgende Kipp- bzw. Flip-Flop-Schaltungen (40, 41; 50, 51) in einer Gesamtheit von in einer Schleifen-Schieberegister-Konfiguration verbundenen Kippschaltungen aktivieren, und daß ein ExklusivODER-Gatter (43, 53), das die Ausgangsgrößen der beiden aufeinanderfolgenden Kippschaltungen des Schieberegisters zugeführt erhält, ein Alarmsignal (AL) abgibt.

2. Überwachungsvorrichtung nach Anspruch 1,
dadurch gekennzeichnet, daß der Zustand des Alarmsignals in einer Kippschaltung (54) gespeichert wird, welche durch die Inversion eines der Taktsignale (CK1) aktiviert wird.

## Claims

1. A device for checking the skew between two clock signals among a plurality of clock signals (CK1-CKn) having the same frequency, characterized in that the two clock signals of each possible pair of clock signals respectively enable two successive flip-flops (40, 41; 50, 51) initially set at distinct states, in a set of flip-flops connected in a looped shift register configuration, and in that an alarm signal (AL) is provided by an Exclusive-OR gate (43, 53) receiving the outputs of two successive flip-flops of the shift register.

2. The checking device of claim 1, wherein the state of the alarm signal is stored in a flip-flop (54) that is enabled by the complement of one (CK1) of the clock signals.
